(19) Europäisches Patentamt European Patent Office Office européen des brevets

(11) EP 2 343 960 A1

(12) EUROPEAN PATENT APPLICATION

(43) Date of publication:
13.07.2011 Bulletin 2011/28

(51) Int Cl.:
H05K 7/20 (2006.01)     G05D 23/19 (2006.01)

(21) Application number: 09460060.8

(22) Date of filing: 30.12.2009

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA RS

(71) Applicant: ABB Research Ltd.
8050 Zürich (CH)

(72) Inventor: Wojcik, Mariusz
32-552 Plaza (PL)

(74) Representative: Chochorowska-Winiarska,
Krystyna
ABB Sp. z o. o.,
Ul. Zeganska 1
04-713 Warszawa (PL)

(54) **A method for monitoring and control of the operating conditions of a device that contains power electronic components**

(57)     The invention provides a method and a system for monitoring and controlling the conditions of operation of a device (10) that incorporates at least one power electronic component (2, 9). The inventive method uses, suitably interconnected, cordlessly and/or by wire, at least one SAW-type passive temperature sensor (3) made in the surface acoustic wave technology which has been placed on selected power electronic components (2, 9) of the device (10), a base station (5), a measuring computer (7) and a control system (8) of the device (10). The method includes actions realized by means of a computer program implemented in the measuring computer (7) which through a control system (8) controls the operating conditions of the device (10) on the basis of the readings of the current temperature on the monitored power electronic components (2, 9) and preset input parameters entered into the measuring computer (7). This invention provides also a computer program and a power electronic component (2, 9) with an integrated SAW-type temperature sensor (3).

Fig. 2

**Description**

A method for monitoring and control of the operating conditions of a device that contains power electronic components

The invention provides a method and a system for monitoring and controlling the conditions of operation of a device that incorporates power electronic components, applicable in electric power equipment.

Power electronic components found in equipment used in the electric power industry heat up during work due to electric current flowing through them, and they are sources of heat. The increase in temperature depends on the load of individual power electronic components, and excessive temperature often results in their damage which in turn results in lower efficiency of equipment that incorporates such components. Usually several power electronic components are connected with one another forming power electronic modules.

There are known methods and instruments for monitoring the temperature of power electronic modules in order to improve their efficiency.

With this end in view, various cooling systems are used, in most cases they are cooling systems with radiators. The radiators are attached to the power electronic components. Thermal energy is picked up from the power electronic components by the radiators and is dispersed in the environment. This is passive cooling, where thermal energy is dispersed by convection. In order to improve the efficiency of the cooling system, air circulation around the radiators is forced by fans. In a situation where heat must be carried away from the area where the power electronic components are installed, cooling media such as water or glycol solutions are used in the cooling system. The cooling medium carries thermal energy from the power electronic components to radiators situated outside the area where the power electronic components are installed. Very often radiators are additionally cooled by fans. The efficiency of the cooling systems depends mainly on the quality of the connection between the power electronic components and the radiators. The thermal permeability of the connections must be as good as possible so that the radiators can quickly carry the heat away from the power electronic components. Temperature measurement is used to assess the cooling system efficiency. The measurement can be done inside the power electronic module by means of a wire thermometer, either as a measurement of the cooling medium temperature, or as a measurement of the radiator temperature. The temperature measured in this way, whether it is the temperature inside the power electronic module representing the average temperature for the whole power electronic module, or the temperature of the cooling medium or of the radiator, results in a faulty functioning of protections safeguarding the power electronic components against overheating. The inconvenience of such known methods and systems for monitoring the temperature of power electronic modules is the impossibility of monitoring the temperature of individual power electronic components, and therefore the lack of an effective protection of power electronic components against overheating.

There are also known methods and systems for monitoring the temperature of power electronic modules wherein the temperature of power electronic components is measured by means of resistance temperature sensors. The temperature measurement is achieved here by the measurement of the change in the resistance of the resistance sensor. Resistance temperature sensors require a connection with the measuring instrument which will convert the value of the change in resistance to a change in temperature. Safety considerations and the need to protect measuring instruments require the use of insulation between resistance temperature sensors and power electronic components. If resistance temperature sensors with a wire connection to the measuring instrument are used, the sensors must be placed at a safe distance from the power electronic component. In such methods and systems for monitoring the temperature of power electronic modules, measurement of the temperature on the surface of a power electronic component is not possible.

Further, there are known methods and systems for monitoring the temperature of power electronic modules, which employ wireless resistance sensors for sensing the surface temperature of power electronic components. However, they require a power source in the form of a battery or other energy store which must be replaced or replenished from time to time. Large dimensions of even the smallest available wireless resistance temperature sensors prevent them being used on each power electronic component of the power electronic module, whose temperature should be monitored.

Among known temperature sensors there are also SAW temperature sensors, that is sensors whose functioning is based on the surface acoustic wave technology. The functioning of SAW sensors is based on generating an acoustic wave from the energy of a radio wave. SAW sensors are called passive sensors because they do not need a power source for their functioning. The SAW sensor contains an antenna to receive and transmit radio signals, an RC electronic circuit which is connected on one side to the antenna and on the other to a piezoelectric structure, and a piezoelectric board. The RC electronic circuit contains passive electronic components such as resistors and capacitors. The selection of the parameters of the electronic components in the RC electronic circuit determines the resonance frequency at which the SAW sensor will work. The piezoelectric board is sensitive to ambient conditions, and in the case of SAW temperature sensors - to temperature. A change in ambient conditions, such as ambient temperature, causes deformations on the surface of the structure of the piezoelectric board, that is, a change in the parameters of this structure. A SAW sensor functions in such way that a radio wave signal is supplied as a call signal to the RC electronic circuit through the connection with the antenna. With a radio wave signal containing the resonance frequency of the RC electronic circuit, the RC electronic circuit is activated, goes into resonance and generates a surface acoustic wave signal. The generated surface acoustic wave passes across the surface of the piezoelectric board on which it is deformed and its parameters such as, e.g. frequency, amplitude are changed depending on the ambient conditions acting on the surface of the piezoelectric board.

In the case of temperature measurement, in a SAW temperature sensor, the shape of the surface acoustic wave is deformed depending on temperature. The deformed surface acoustic wave signal activates the RC electronic circuit which goes into resonance and generates a radio wave signal which is then transmitted by means of the antenna as the response signal.

Considering the principle of operation, SAW sensors can be divided into two types: resonance sensors and delaying sensors. In resonance SAW temperature sensors, information about temperature is carried by one of the resonance frequencies. The resonance SAW temperature sensors have two RC electronic circuits. The first RC electronic circuit is responsible for generating the surface acoustic wave from the radio wave received by the antenna. The second RC electronic circuit receives the surface acoustic wave which has passed across the structure of the piezoelectric board and by means of it generates the radio wave which is then transmitted through the antenna. The temperature is calculated from the frequency spectrum of the radio wave signal received from the SAW temperature sensor. In the delaying SAW temperature sensors, information about temperature is calculated from the value of the delay between the moment of sending the radio signal and the moment of receiving the response. The delaying SAW temperature sensors have only one RC electronic circuit. The surface acoustic wave signal is reflected by a special barrier at the end of the piezoelectric board and returns to the RC electronic circuit. In the delaying SAW temperature sensors, the temperature of the piezoelectric board affects the time after which the SAW sensor will send, through the antenna and the RC electronic circuit, the radio wave signal with the response.

The inconvenience connected with the use of SAW temperature sensors is the limited number of sensors that can be used in a specific area. The use of a larger number of resonance SAW temperature sensors requires the use of sensors tuned to different resonance frequencies, whereas the use of a larger number of delaying SAW temperature sensors requires the use of sensors of different degree of delay.

The known methods and systems for controlling the operating conditions of devices containing power electronic components employ control systems optimized with respect to the control of power electronic modules, and capable of fast execution of the loop of the controlling computer program. The capabilities of the control systems are fully used so that the accumulation of a large number of data and their processing is excluded.

**The aim of the invention is the development of a method and a system for monitoring and control of the operating conditions** of any device that incorporates any number of power electronic components, which would eliminate the above mentioned inconveniences of the known solutions and would ensure a reliable operation of devices irrespective of their configuration, intended use, situation, ambient conditions, spatial and other limitations.

Another aim of the invention is the development of a method and a system for monitoring and control of the operating conditions of a device that incorporates power electronic components, which would provide the monitoring of the current temperature of selected power electronic components or selected power electronic modules with a selected control frequency, as necessary.

Furthermore, the method and the system for monitoring and control of the operating conditions of a device containing power electronic components, according to the invention, are expected to permit the current control of other operating parameters of power electronic components or modules, such as the uniformity of their load or their efficiency, owing to the assurance of a reliable continuous cooperation with the internal system for controlling the device.

Still another aim of the invention is the development of a method and a system for monitoring and control of the operating conditions of a device that incorporates power electronic components, which would offer a possibility of simple, easily adaptable to changing needs, and reliable in every conditions control of the operation of such device according to parameters adequate to the needs, preset and/or calculated in a measuring computer.

Another aim of the invention is the development of a method of monitoring temperature which would allow temperature measurement directly on the surface of the power electronic components without any limitations connected with the need to ensure galvanic separation between the power electronic components and the controlling or monitoring electronic components.

The object of the invention is the reduction of the costs of the realization of the method and the cost of operating the system, as well as an increase in its reliability.

**The method and the system for monitoring and control of the operating conditions of a device containing at least one power electronic component, according to the invention,** employs suitably interconnected, cordlessly or by wire, at least one SAW-type passive temperature sensor made in the surface acoustic wave technology, a base station, a measuring computer with a processor, and a control system of the device, and which consists in the following:

- on the selected at least one power electronic component of the device there is placed at least one SAW-type passive temperature sensor and by means of it the temperature of that selected power electronic component is measured using the base station of the SAW temperature sensors during the operation of the device;
- after processing, the measured data are transmitted to the measuring computer to which there are supplied preset input parameters and information about the voltage and intensity of current flowing through the selected at least one power electronic component, which information is obtained from the control system used for measuring and controlling the operation of at least one power electronic component; after which
- on the basis of the signal informing about the temperature of the power electronic component received from the base station the control parameters are calculated in the measuring computer and by means of the control system the signals that switch the power electronic component on and off are controlled.

Preferably, at least one radiator functioning independently or operating in a cooling system furnished with a controlling unit and a network of connections between the radiators and the controlling unit is placed on at least one selected power electronic component.

Preferably, a SAW temperature sensor of any type, including the resonance type and/or the delaying type is used as the SAW temperature sensor made in the surface acoustic wave technology.

Preferably, a sensor built into the power electronic component which is an integrated SAW sensor and/or a sensor attached to the outside of the housing of the power electronic component is/are used as the SAW temperature sensor made in the surface acoustic wave technology.

Preferably, at least one signal from the following group of signals is selected as the signals of the preset control parameters: the signal about how uniformly the power electronic components are loaded, the signal about the current temperature of each monitored power electronic component, the signal about the current efficiency of each monitored power electronic component, and the signal about the cooling effectiveness, whereas as the preset input parameters are selected respectively the values of the maximum temperature, efficiency characteristics, steady-state values one and two of the current temperature, the values of the limiting temperatures.

Preferably, the measurement of the temperature of the power electronic component by the SAW-type temperature sensor, the transmission of the preset control parameters calculated in the measuring computer to the control system of the device, the collection by the control system of information on the voltage and intensity of current flowing through the power electronic component, and the transmission by the control system of the signal informing about the voltage and intensity of current flowing through the power electronic component to the measuring computer is done with a selected frequency, for instance, with a frequency of 1 per second.

Preferably, an inverter is used as the device.

**The system for the implementation of the method of monitoring and controlling the operating conditions of the device that incorporates at least one power electronic component, according to the invention,** comprises:

- at least one SAW-type passive temperature sensor made in the surface acoustic wave technology placed on the selected at least one power electronic component of the device;
- a base station of the SAW temperature sensors, used for transmitting a radio call signal to the said temperature sensor and for receiving the radio response signal from the SAW temperature sensor by means of an antenna;
- a measuring computer comprising a processor, function modules for carrying out calculation functions, and a module for controlling the monitoring of the conditions of the power electronic components, and used to calculate the preset control parameters and to transmit the calculated preset control parameters in the form of digital signals of the preset control parameters to the control system of the device, while
- the preset control parameters are calculated on the basis of the signal informing about the temperature of the power electronic component (2, 9) received from the base station, the preset input parameters, and the signal informing about the voltage and current on the power electronic component received from the control system,
- the control system (8) of the device (10) that incorporates a measuring system collecting information about the voltage and intensity of current flowing through the power electronic component (2, 9) from the selected at least one power electronic component, and used for processing and transmitting the signal informing about the voltage and intensity of current flowing through the power electronic component to the measuring computer, for receiving the signals of the preset control parameters from the measuring computer, for converting the signals of the preset control parameters to signals switching off and on the power electronic component or components.

Preferably, the system has at least one radiator functioning independently or operating in a cooling system furnished with a controlling unit and a network of connections between the radiators and the controlling unit, which radiator is placed on at least one selected power electronic component.

Preferably, the SAW temperature sensor made in the surface acoustic wave technology is a SAW temperature sensor of any type, including the resonance type and/or the delaying type.

Preferably, the SAW temperature sensor made in the surface acoustic wave technology is a sensor built into the power electronic component forming an integrated SAW sensor and/or it is a sensor attached to the outside of the housing of the electronic component.

Preferably, the function modules for carrying out the calculating functions of the measuring computer are in a number adequate to the function of the system and are selected from a group including a function module M1 for monitoring how uniformly the individual power electronic components are loaded, function modules M2 for quick protection of individual power electronic components, function modules M3 for monitoring the efficiency of individual power electronic components, function modules M4 for monitoring the cooling efficiency.

Preferably, the device is an inverter.

**The computer program for monitoring and control of the operating condition of a device containing power electronic components,** according to the invention, is loadable to and executable in the measuring computer, and it is characterized by the fact that it realizes the method according to the invention.

**The power electronic component, according to the invention,** has a housing with an internal semiconductor structure, and is characterized in that it has an in-built and enclosed in the housing cordless passive SAW-type temperature sensor so that the antenna of the SAW temperature sensor sticks out of the housing of the power electronic component with the integrated SAW temperature sensor.

**The advantage of the invention is that** it considerably reduces the costs of the realization of the method and the operation of the system for monitoring and control of the operating conditions of a device that incorporates power electronic components, by continuously monitoring the efficiency of all desired power electronic components, which allows their earlier replacement if their efficiency is reduced and thus makes it possible to reduce the number of failures which would otherwise result in longer stoppages caused by damage to power electronic components. In the particular preferable embodiment of the invention with a measuring computer fitted with the module for monitoring the uniformity of the load of the power electronic components, the individual power electronic components are protected against overheating and therefore also against undesirable accelerated ageing.

Another advantage of the invention is that by ensuring the realization of the basic control actions outside the control system of the device with power electronic components, which has a limited computing power, the reliability of the method and the system according to the invention is considerably increased.

An advantage of the invention is also that the use of wireless passive SAW temperature sensors allows to eliminate problems connected with the need to provide cabling and to replace batteries. The execution of the method and the operation of the system have been simplified owing to the automatic operation of the SAW temperature sensors.

Wireless temperature measurement has eliminated the need to ensure separation between components with different potentials, namely between power electronic components which normally operate on high potential and electronic components responsible for control or monitoring which normally work on a potential not exceeding 5 V. The high potential of the power electronic components depends on the intended use of the device in which they are incorporated. The potential at which power electronic components operate ranges from 230 V to 3.3 kV or even more for high voltage devices. Owing to the use of wireless SAW temperature sensors, the electronic components responsible for control or monitoring are, in this system, intrinsically separated from the power electronic components.

Yet another advantage of the invention is that the small size of SAW temperature sensors permits their placement directly on each desired power electronic component of the device whose operating conditions we want to control.

An important advantage of method and system according to the invention is that they permit control of the operation of practically any number of power electronic components, and hence of any power electric device irrespective of its intended use, size, situation, ambient conditions and other limitations.

Use of power electronic components with the integrated SAW temperature sensor according to the invention ensures very precise measurement of current temperature of the surface of a power electronic component and additionally reduces the cost of implementation of the inventive system.

**The subject of the invention is shown in preferable embodiments in the drawing** where fig. 1 shows the block diagram of the system according to the invention for monitoring and control of the operating conditions of the device containing one power electronic component, fig. 2 shows the block diagram of the system according to the invention, wherein external SAW temperature sensors fixed to power electronic components have been used, fig. 3 shows the block diagram of the system according to the invention, wherein SAW temperature sensors integrated with power electronic components have been used, fig. 4 shows the block diagram of the system according to the invention including the blocks of the framework actions of the method according to the invention, and fig. 5 shows the block diagram of a power electronic component with an integrated SAW temperature sensor according to the invention.

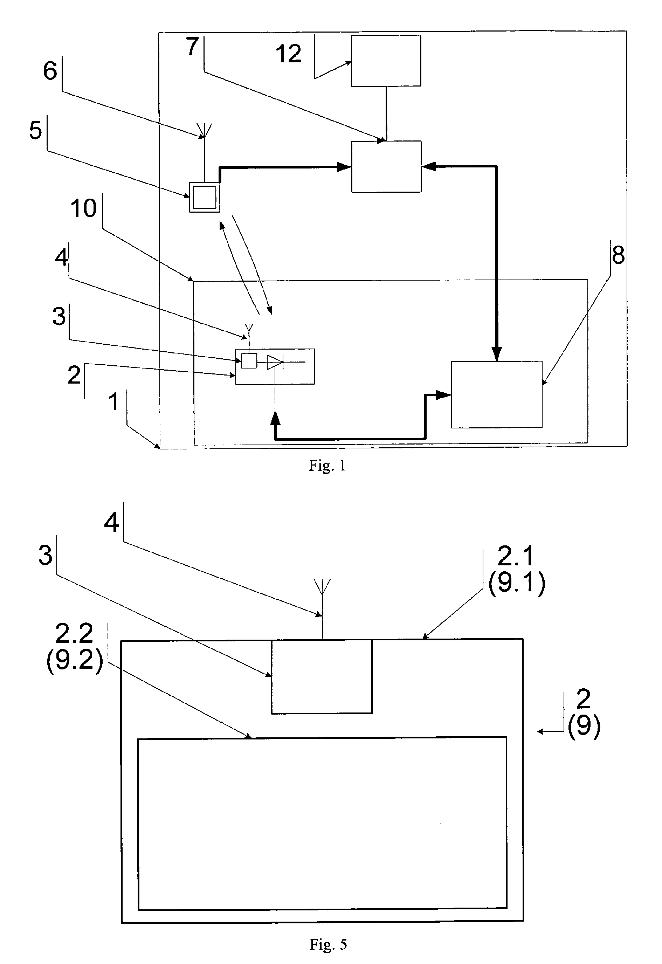

**Fig. 1 presents** the block diagram of the simplest embodiment of the system 1, according to the invention, for monitoring and control of the operating conditions of the device 10 incorporating one power electronic component 2 of type I or 9 of type II, while the power electronic component 2 of the type I can be a diode, a thyristor, a transistor, and the power electronic component 9 of the type II can be a thyristor, a transistor. In fig. 1 there is shown, by way of example, a power electronic component with an integrated SAW temperature sensor 3, according to the invention, which has been built into the power electronic component 2 and has been enveloped in its housing 2.1 (or housing 9.1 in the case of the power electronic component 9 of type II). The SAW temperature sensor 3 can also be fixed to the outside of the casing 2.1 of the power electronic component 2 by means of glue or mechanical means, for example a screw. The SAW temperature sensor is a passive wireless sensor. The sensor 3 is fitted with an antenna 4 which receives radio call signals from the antenna 6 of the base station 5 and transmits radio response signals to the antenna 6 of the base station 5. The radio response signals contain information about the temperature of the power electronic component 2, 9. The temperature of the power electronic component 2, 9 is measured with a preselected control frequency as necessary, for instance, with a frequency of 1 per second. On the other side the power electronic component 2, 9 is connected to the control system 8 of the device 10. The control system 8 is fitted with a measuring system which collects information about the voltage and intensity of current flowing through the power electronic component 2, 9 from the power electronic component 2, 9. The base station 5 using signal processing means converts the received radio response signals to digital signals informing about the temperature of the power electronic component 2, 9, which it transmits by wire or cordlessly to the measuring computer 7. The transmission of the signals informing of the temperature of the power electronic component 2, 9 from the base station 5 to the measuring computer 7 can employ the USB protocol or other method of digital communication. The measuring computer 7 comprises a processor 7.1, function modules M1, M2, M3, M4 for carrying out computing functions on the basis of preselected input parameters entered into the system 1 via an operator's panel 12 added to the measuring computer 7 and a module M5 for controlling the monitoring of the condition of the power electronic components 2, 9 with an implemented computer program. The function module M1 monitors the uniformity of the load of individual selected power electronic components 2, 9. In this embodiment of the system 1, according to the invention, with one power electronic component 2, 9, the presence of the function module M1 is not necessary, as shown in fig. 1. However, if the system 1, according to the invention, fitted with the function module M1, is used for the device 10 with only one power electronic component 2, 9, the value of the signal of the set control parameter of the function module M1 about the uniformity of the load of that power electronic component 2, 9 would equal 0. The role of the function module M2 is to quickly protect the power electronic component 2, 9 on the basis of the received information on the current temperature of the power electronic component 2, 9. If the maximum temperature for the power electronic component 2, 9 is exceeded, the function module M2 will switch off the power electronic component 2, 9 through module M5 for controlling the monitoring of the condition of the power electronic components 2, 9 and through the control system 8. The value of the maximum temperature for the given power electronic component 2, 9 is entered, based on the manufacturer's data, to the system 1 via the operator's panel 12. The task of the function module M3 is to monitor the current efficiency of the power electronic component 2, 9. Based on information received from the base station 5 on the current temperature of the power electronic component 2, 9 and information received from the control system 8 on the voltage and intensity of current flowing through the power electronic component 2, 9, the function module M3 will calculate the current efficiency of the power electronic component 2, 9 and will transmit this information to the control system 8 which can suitably switch on or off the power electronic component 2, 9. The signals of the set control parameters calculated in the measuring computer 7 are transmitted to the control system 8 of the device 10 with a selected needed frequency, for instance, with a frequency of 1 per second, whose value is entered into the measuring computer 7 via the operator's panel 12. Similarly, information about the voltage and intensity of current flowing through power electronic component 2, 9 is collected by the measuring system of the control system 8 and then, after being processed using means of converting the signals of the control system 8 to a digital signal informing about the voltage and intensity of current flowing through the power electronic component 2, 9, it is transmitted to the measuring computer 7 with a selected needed frequency, for instance, with a frequency of 1 per second, whose value is entered into the measuring computer 7 via the operator's panel 12.

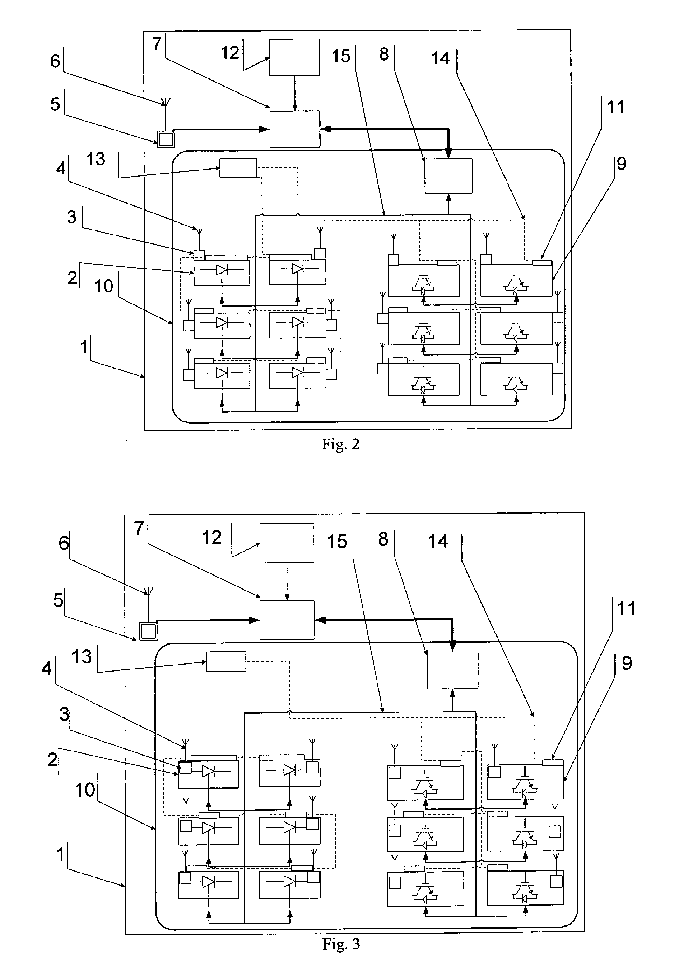

**Fig. 2 presents** the block diagram of a preferable embodiment of the system 1, according to the invention, for monitoring and control of the operating conditions of the device 10 which in this case is an inverter which converts electric energy parameters such as voltage and voltage frequency, current intensity and current intensity frequency. The inverter has the system 8 controlling the operation of the power electronic components 2, 9 whose operation is significantly improved by cooperation with the system 1, according to the invention. The device 10 contains many power electronic components 2 of type I or 9 of type II, while the power electronic component 2 of the type I can be a diode, a thyristor, a transistor, and the power electronic component 9 of the type II can be a thyristor, a transistor. In fig. 2 there are shown, by way of example, power electronic components with SAW temperature sensors 3 which have been attached to the outside of the casing 2.1, 9.1 of the power electronic component 2, 9 by means of glue or mechanical means, for example a screw. The SAW temperature sensors can be, however, exclusively or also SAW temperature sensors integrated with the power electronic component 2, 9. The SAW temperature sensor is a wireless passive sensor and it can be, depending on the needs or the intended use of the system 1, placed on all or selected power electronic components 2, 9 of the device 10. Fig. 2 shows by way of example the system 1 with a SAW temperature sensor 3 placed on all power electronic components 2, 9 of the device 10. Fig. 2 shows the system 1 according to the invention with a cooling system whose task is reception of thermal energy from the power electronic components 2, 9 during the operation of the device 10 and its conduction outside the device 10. The cooling system incorporates radiators 11 placed on the power electronic components 2, 9 and through a network of connections 14 connected with a control unit 13 which conducts thermal energy outside the device 10. The system 1 according to the invention can incorporate the radiators 11 working independently i.e. as not connected into the cooling system as shown in fig. 2. The SAW temperature sensor 3 is fitted with an antenna 4 which receives radio call signals from the antenna 6 of the base station 5 and transmits radio response signals to the antenna 6 of the base station 5. The radio response signals contain information about the temperature of the power electronic component 2, 9. The temperature of the power electronic component 2, 9 is measured with a preselected control frequency as necessary, for instance, with a frequency of 1 per second. On the other side the power electronic component 2, 9 is connected to the control system 8 of the device 10. The control system 8 is fitted with a measuring system which uses a network of connections 15 to collect from each of the monitored power electronic components 2, 9 information about the voltage and intensity of current flowing through each such power electronic component 2, 9. The base station 5 of the SAW temperature sensors 3, using signal processing means, converts the received radio response signals to digital signals informing about the temperature of each power electronic component 2, 9 and transmits them to the measuring computer 7 by wire or wirelessly. The transmission of the signals informing of the temperature of individual power electronic components 2, 9 from the base station 5 to the measuring computer 7 can, preferably, be accomplished by means of the USB protocol or other method of digital communication. Measuring computer 7 comprises a processor 7.1, function modules M1, M2, M3, M4 for performing calculation functions based on preset input parameters entered into the system 1 via the operator's panel 12 added to the measuring computer 7, and module M5 for controlling the monitoring of the condition of the power electronic components 2, 9 with an implemented computer program.

The operator's panel 12 permits the entering into the measuring computer 7 of preset, depending on the intended use of the system 1, input parameters and browsing through them. The input parameters entered via the operator's panel 12 are the technical parameters of the monitored power electronic components 2, 9 such as the maximum temperature values for each power electronic component 2, 9, efficiency characteristics for each power electronic component 2, 9, steady-state values one and two of the current temperature for each power electronic component 2, 9 and the values of the limiting temperatures at which the signals of the set control parameters are sent from the measuring computer 7 to the control system 8, which signals are then converted using means of processing the signals of the control system 8 to switch-off and switch-on signals sent to the proper power electronic component 2, 9. Other input parameters entered via the operator's panel 12 include also the values of the frequency with which the signals of the set control parameters calculated in the function modules M1, M2, M3 and M4 of the measuring computer 7 are transmitted to the control system 8 of the device 10 and the values of the frequency with which the current temperature on each monitored power electronic component 2, 9 is to be measured by means of the SAW temperature sensor 3, as well as the values of the frequency with which information about the voltage and intensity of current flowing through the power electronic component 2, 9 is collected by the measuring system of the control system 8 and then, after their conversion to a digital signal informing about the voltage and intensity of current flowing through the power electronic component 2, 9, the values of the frequency with which they are transmitted to the measuring computer 7. All input parameters entered into the measuring computer 7 as well as data processed therein can be browsed, according to the calculated sequences and/or historically, owing to the fact that they are stored in a database 7.2.

In the function modules M1, M2, M3, M4, the set control parameters are calculated and through the module M5 for controlling the monitoring of the condition of the power electronic components 2, 9 they are transmitted in the form of digital signals of the set control parameters to the control system 8 of the device 10.

**And so, the task of the function module M1** is the monitoring of the uniformity of the load of individual selected power electronic components 2, 9. The determination of the load uniformity is based on temperature measurement of individual power electronic components 2, 9. A difference in temperature between the power electronic components 2, 9 indicates that their load is unequal. The signal of the set control parameter of the function module M1 about the uniformity of the load of the power electronic components 2, 9 is a signal in the range of minus 100 to 100, where 0 means that the monitored power electronic component 2, 9 is loaded at a uniform rate with the other components, for example, the value 10 of this signal means that the power electronic component 2, 9 is loaded more than the other ones, according to this formula:

$$\alpha_i = \frac{T_{sr} - T_i}{T_{sr}} \text{, where}$$

$\alpha_i$ - the load factor of the power electronic component i,

$T_{sr}$ - the arithmetic mean of the temperatures of all monitored power electronic components,

$T_i$ - the temperature of the power electronic component i for which the load factor is calculated.

**The task of the function module M2** is to quickly protect the power electronic component 2, 9 on the basis of the received information on the current temperature of the power electronic component 2, 9. The number of the function modules M2 corresponds to the number of the monitored power electronic components 2, 9. The function module M2 transmits information about the current temperature of the power electronic components 2, 9 measured by the SAW temperature sensors 3. The signal of the set control parameter of the function module M2 about the current temperature of the power electronic component 2, 9 is a signal of a value 0 or 1, where 1 means that the monitored power electronic component 2, 9 is overheated. Therefore, if the maximum temperature for the power electronic component 2, 9 is exceeded, the function module M2 will switch off this power electronic component 2, 9 through the module M5 for controlling the monitoring of the condition of the power electronic components 2, 9 and through the control system 8. The value of the maximum temperature for the given power electronic component 2, 9 according to the manufacturer's data is entered into the system 1 via the operator's panel 12 as one of the preset input parameters. The maximum temperature of the power electronic component 2, 9 depends on the type of the power electronic component 2, 9 and on the cooling system used. For example, for a power electronic component 2 of the type I in the form of a diode, the maximum temperature is about 170°C.

**The task of the function module M3** is monitoring the current effectiveness of the power electronic component 2, 9. The number of the function modules M3 corresponds to the number of the monitored power electronic components 2, 9. On the basis of information about the current temperature of the power electronic component 2, 9 received from the base station 5 and information about the voltage and intensity of current flowing through the power electronic component 2, 9 received from the control system 8, the function module M3 will calculate the current efficiency of the power electronic component 2, 9 and through the module M5 for controlling the monitoring of the condition of the power electronic components 2, 9 it will transmit this information to the control system 8 which can suitably switch on or off the power electronic component 2, 9. The efficiency of each power electronic component 2, 9 is the ratio of the electric power flowing into the power electronic component 2, 9 to the power flowing out of it, while the loss on the power electronic component 2, 9 is converted to heat. To be precise, the efficiency of each power electronic component 2, 9 is calculated on the basis of the parameters of the power electronic components 2, 9 supplied by the manufacturer. Each power electronic component 2, 9 has a specification in which the manufacturer states the efficiency of the power electronic component 2, 9 expressed by the level of energy loss on this power electronic component 2, 9. The efficiency characteristic for each monitored power electronic component 2, 9 according to the manufacturer's data is entered into the measuring computer 7 via the operator's panel 12 as one of the preset input parameters. The level of energy loss on the power electronic component 2, 9 depends on the voltage and intensity of current flowing through it, so a signal informing about the current voltage and intensity of current on the power electronic component 2, 9 is reported from the control system 8 to the function module M3. The theoretical value of the energy loss on the power electronic component 2, 9 is calculated in the function module M3 on the basis of the characteristics of the power electronic component 2, 9 and the knowledge of the current values of the voltage and intensity of the current. Since the energy loss on the power electronic component 2, 9 is converted to heat, the theoretical value of energy loss on the power electronic component 2, 9 is used to calculate the theoretical temperature on the power electronic component 2, 9 which is then compared with the current temperature measured by the SAW temperature sensors 3. With ageing of power electronic components 2, 9 their efficiency deteriorates and thereby energy losses on the power electronic components 2, 9 grow. The signal of the set control parameter of the function module M3 about the current efficiency of the power electronic component 2, 9 is a signal in the range of 0 to 100, where 100 means that the power electronic component 2, 9 operates at maximum efficiency. If the ideal efficiency is lower than the current efficiency calculated from the measurement of the current temperature of the power electronic component 2, 9, the value 100 is transmitted to the control system 8.

**The task of the function module M4** is monitoring the efficiency of the cooling system on the basis of time-constants calculated from the current temperature sequences for the heating and cooling of power electronic components 2, 9. The number of the function modules M4 corresponds with the number of monitored power electronic components 2, 9. The temperature-sequence time-constants are determined as follows. If we have the given temperature sequence, e.g. for heating, i.e. for a temperature increase from the initial value to a stabilized higher temperature, we draw tangents to the temperature curve and it is the basis for determining time-constants. In the function module M4, time-constants are calculated from each temperature rise-cycle, from the first stabilized value of current temperature to the second stabilized value of current temperature. If the second stabilized value of current temperature is higher than the first stabilized value of current temperature, we have to do with heating and with heating time-constants. Otherwise, if the second stabilized value of current temperature is lower than the first stabilized value of current temperature, we have to do with cooling and with cooling time-constants. The stabilized values of the current temperature one and two are entered into the measuring computer 7 via the operator's panel 12 as preset input parameters. The signal of the set control parameter of the function module M4 about the efficiency of the cooling system, which is transmitted to the control system 8 via the module M5 for controlling the monitoring of the condition of the power electronic components 2, 9, is an information signal about the heating and cooling time-constants.

The above mentioned signals of the set control parameters calculated in the function modules M1, M2, M3 and M4 of the measuring computer 7 are transmitted to the control system 8 of the device 10 with a selected required frequency, for instance, with a frequency of 1 per second, whose value is entered into the measuring computer 7 via the operator's panel 12. Similarly, information about the voltage and intensity of current flowing through power electronic component 2, 9 is collected by the measuring system of the control system 8, and then, after being processed using means of converting the signals of the control system 8 to a digital signal informing about the voltage and intensity of current flowing through the power electronic component 2, 9, it is transmitted to the measuring computer 7 with a selected needed frequency, for instance, with a frequency of 1 per second, whose value is entered into the measuring computer 7 via the operator's panel 12.

**Fig. 3 presents** the block diagram of another preferable embodiment of the system 1, according to the invention, for monitoring and control of the operating conditions of the device 10 which is, as in fig. 2, an inverter. In this system 1, SAW temperature sensors 3 integrated with the power electronic components 2, 9 have been used as sensors built into the power electronic components 2, 9. The other components of the system 1 and its operation are the same as those described above for fig. 2.

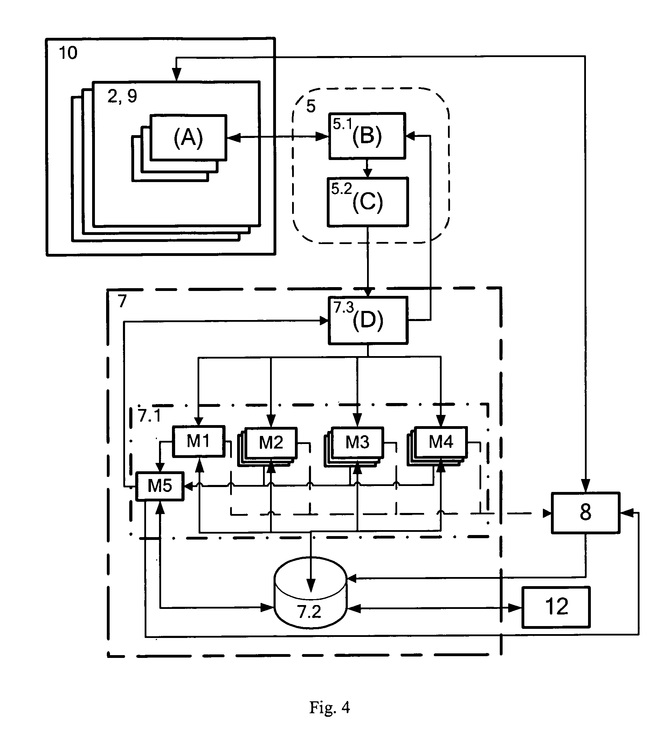

**Fig. 4 presents** the block diagram of the system 1 for monitoring and control of the operating conditions of the device 10 incorporating at least one power electronic component 2, 9, according to the invention, including the blocks of the framework actions of the method of monitoring and control of the operating conditions of the device 10 comprising at least one power electronic component 2, 9, according to the present invention. The block A schematically pictures the action of reading the current temperature on the monitored power electronic component 2, 9 of the device 10 by means of a passive SAW temperature sensor 3 made in the surface acoustic wave technology. Outside the device 10 there is situated the base station 5 of the SAW temperature sensors 3, which, during the operation of the device 10, through the antenna 6 of a transmission-reception port 5.1, transmits radio call signals to the SAW temperature sensors 3 and receives from them radio response signals which it then converts, using signal processing means, into digital signals informing about the temperature of the monitored power electronic components 2, 9, which is pictured by the block B. Then, the block C pictures actions performed by the communication port 5.2 of the base station 5 of the SAW temperature sensors 3, that is, the transmission of digital signals informing about the temperature of the monitored power electronic components 2, 9 to the communication port 7.3 of the measuring computer 7. The digital signals informing about the current temperature of each monitored power electronic component 2, 9 can be transmitted to the communication port 7.3 wirelessly or by wire, preferably by means of the USB protocol or other method of digital communication. Moreover, as pictured by the block D, the communication port 7.3 sends to the base station 5 signals about the value of the frequency with which the current temperature is to be read by means of the SAW temperature sensors 3 on each monitored power electronic component 2, 9, these frequency values being entered via the operator's panel 12 as preset input parameters. The measuring computer 7 incorporates a processor 7.1 with function modules M1, M2, M3, M4 and a module M5 for controlling the monitoring of the condition of the power electronic components 2, 9 with an implemented computer program. The measuring computer 7 contains also a database 7.2 which stores all input parameters entered into the measuring computer 7 as well as information about the current and historical temperature of the monitored power electronic components 2, 9 and the data of calculated sequences according to the implemented computer program.

**Fig. 5 shows** a block diagram of the power electronic component 2, 9 with an integrated SAW temperature sensor 3, according to the invention. The power electronic component 2, 9 has a casing 2.1, 9.1 with an internal semiconductor structure 2.2, 9.2 of type N or P. The wireless passive SAW temperature sensor 3 is built into the power electronic component 2, 9 and is enveloped by its housing 2.1, 9.1 in such way that the antenna 4 of the SAW temperature sensor 3 protrudes outside the casing 2.1, 9.1.

List of components

1. System of monitoring and control ... according to the invention
2. Power electronic component type I
2.1 Housing of power electronic component type I
2.2 Semiconductor structure of power electronic component type I
3. SAW temperature sensor
4. Antenna (of SAW temperature sensor 3)
5. Base station
5.1 Transmission-reception port with signal-processing means

5.2 Communication port (of base station 5)

6. Antenna (of base station 5)

7. Measuring computer

7.1 Processor

7.2 Database

7.3 Communication port (of measuring computer 7)

8. Control system

9. Power electronic component type II

9.1 Housing of power electronic component type II

9.2 Semiconductor structure of power electronic component type II

10. Device with at least one power electronic component

11. Radiator

12. Operator's panel

13. Control unit (of the cooling system)

14. Cooling system connection network

15. Connection network of the measuring system of the control system 8

**Claims**

1. A method for monitoring and control of the operating conditions of a device (10) that incorporates at least one power electronic component (2, 9) using suitably interconnected, by wire or cordlessly, at least one SAW-type passive temperature sensor (3) made in the surface acoustic wave technology, a base station (5), a measuring computer (7) with a processor (7.1) and a control system (8) of the device (10), which includes the following actions:

   - on the selected at least one power electronic component (2, 9) of the device (10) there is placed at least one SAW-type passive temperature sensor (3) and by means of it the temperature of that selected power electronic component is measured using the base station (5) of the SAW temperature sensors (3) during the operation of the device (10) ;

   - after processing, the measured data are transmitted to the measuring computer (7), to which there are supplied preset input parameters and information about the voltage and intensity of current flowing through the selected at least one power electronic component (2, 9), which information is obtained from the control system (8) used for measuring and controlling the operation of at least one power electronic component (2, 9);

   after which

   - on the basis of the signal informing about the temperature of the power electronic component (2,9) received from the base station (5) the control parameters are calculated in the measuring computer (7) and by means of the control system (8) the signals that switch the power electronic component (2,9) on and off are controlled.

2. A method according to claim 1, **characterized in that** at least one radiator (11) functioning independently or operating in a cooling system furnished with a controlling unit (13) and a network (14) of connections between the radiators (11) and the controlling unit (13) is placed on at least one selected power electronic component (2, 9).

3. A method according to claim 1 or 2, **characterized in that** a SAW temperature sensor (3) of any type, including the resonance type and/or the delaying type is used as the SAW temperature sensor (3) made in the surface acoustic wave technology.

4. A method according to claim 1 or 2 or 3, **characterized in that** a sensor built into the power electronic component (2, 9) which is an integrated SAW sensor and/or a sensor attached to the outside of the housing (2.1, 9.1) of the power electronic component (2, 9) is/are used as the SAW temperature sensor (3) made in the surface acoustic wave technology.

5. A method according to any of the previous claims, **characterized in that** at least one signal from the following group of signals is selected as the signals of the preset control parameters: the signal about how uniformly the power electronic components (2, 9) are loaded, the signal about the current temperature of each monitored power electronic component (2, 9), the signal about the current efficiency of each monitored power electronic component (2, 9), and the signal about the cooling effectiveness,
   whereas
   as the preset input parameters are selected respectively the values of the maximum temperature, efficiency characteristics, steady-state values one and two of the current temperature, the values of the limiting temperatures.

6. A method according to any of the previous claims, **characterized in that** the measurement of the temperature of the power electronic component (2, 9) by the SAW-type temperature sensor (3), the transmission of the preset control parameters calculated in the measuring computer (7) to the control system (8) of the device (10), the collection by the control system (8) of information on the voltage and intensity of current flowing through the power electronic component (2, 9), and the transmission by the control system (8) of the signal informing about the voltage and intensity of current flowing through the power electronic component (2, 9) to the measuring computer (7) is done with a selected frequency, for instance, with a frequency of 1 per second.

7. A method according to any of the previous claims, **characterized in that** an inverter is used as the device (10).

8. A system for the implementation of the method of monitoring and controlling the operating conditions of the device (10) that incorporates at least one power electronic component (2, 9) according to claim 1-7, where the system comprises:

    - at least one SAW-type passive temperature sensor (3) made in the surface acoustic wave technology placed on the selected at least one power electronic component (2, 9) of the device (10);
    - the base station (5) of the SAW temperature sensors (3), used for transmitting a radio call signal to the said temperature sensor (3) and for receiving the radio response signal from the SAW temperature sensor (3) by means of an antenna (6);
    - the measuring computer (7) comprising a processor (7.1), function modules for carrying out calculation functions, and a module (M5) for controlling the monitoring of the conditions of the power electronic components (2, 9), and used to calculate the preset control parameters and to transmit the calculated preset control parameters in the form of digital signals of the preset control parameters to the control system (8) of the device (10), while
    the preset control parameters are calculated on the basis of the signal informing about the temperature of the power electronic component (2, 9) received from the base station (5), the preset input parameters, and the signal informing about the voltage and current on the power electronic component (2, 9) received from the control system (8),
    - the control system (8) of the device (10) which control system incorporates a measuring system used for collecting information about the voltage and intensity of current flowing through the power electronic component (2, 9) from the selected at least one power electronic component (2, 9) and used for processing and transmitting the signal informing about the voltage and intensity of current flowing through the power electronic component (2, 9) to the measuring computer (7), for receiving the signals of the preset control parameters from the measuring computer (7), for converting the signals of the preset control parameters to signals switching off and on the power electronic component or components (2, 9).

9. A system according to claim 8, **characterized in that** it has at least one radiator (11) functioning independently or operating in a cooling system furnished with a controlling unit (13) and a network (14) of connections between the radiators (11) and the controlling unit (13), which radiator is placed on at least one selected power electronic component (2, 9).

10. A system according to claim 8 or 9, **characterized in that** the SAW temperature sensor (3) made in the surface acoustic wave technology is a SAW temperature sensor (3) of any type, including the resonance type and/or the delaying type.

11. A system according to claim 8 or 9 or 10, **characterized in that** the SAW temperature sensor (3) made in the surface acoustic wave technology is a sensor built into the power electronic component (2, 9) forming an integrated SAW sensor and/or it is a sensor attached to the outside of the housing (2.1, 9.1) of the power electronic component (2, 9).

12. A method according to any of the previous claims, **characterized in that** the function modules for carrying out the calculating functions of the measuring computer (7) are in a number adequate to the function of the system (1) and are selected from a group including a function module M1 for monitoring how uniformly the individual power electronic components (2, 9) are loaded, function modules M2 for quick protection of individual power electronic components (2, 9), function modules M3 for monitoring the efficiency of individual power electronic components (2, 9), function modules M4 for monitoring the cooling efficiency.

13. A method according to any of the previous claims, **characterized in that** the device (10) is an inverter.

14. A computer program for monitoring and control of the operating condition of a device that incorporates power electronic components, which is loadable to and executable in the measuring computer (7), **characterized in that** during its run it realizes the method according to claims 1-7.

15. A power electronic component containing a housing (2.1, 9.1) with an internal semiconductor structure (2.2, 9.2), **characterized in that** it has an in-built (2.1, 9.1) cordless passive SAW-type temperature sensor (3) enclosed in a housing, so that the antenna (4) of the SAW temperature sensor (3) sticks out of the housing (2.1, 9.1) of the power electronic component (2, 9) with the integrated SAW temperature sensor (3).

Fig. 1

Fig. 5

Fig. 2

Fig. 3

Fig. 4

Europäisches
Patentamt

European
Patent Office

Office européen
des brevets

## EUROPEAN SEARCH REPORT

**Application Number**

EP 09 46 0060

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 2 007 184 A2 (GEN ELECTRIC [US]) 24 December 2008 (2008-12-24) * the whole document * | 1-15 | INV. H05K7/20 G05D23/19 |
| A | US 2009/167503 A1 (COOK JAMES D [US] ET AL) 2 July 2009 (2009-07-02) * the whole document * | 1-15 | |

| TECHNICAL FIELDS SEARCHED (IPC) |
|---|
| H05K G05D |

The present search report has been drawn up for all claims

| Place of search | Date of completion of the search | Examiner |
|---|---|---|
| Munich | 12 May 2010 | Sundin, Martin |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

................................................................
& : member of the same patent family, corresponding
  document

EPO FORM 1503 03.82 (P04C01)

EP 2 343 960 A1

## ANNEX TO THE EUROPEAN SEARCH REPORT
## ON EUROPEAN PATENT APPLICATION NO.

EP 09 46 0060

This annex lists the patent family members relating to the patent documents cited in the above-mentioned European search report.
The members are as contained in the European Patent Office EDP file on
The European Patent Office is in no way liable for these particulars which are merely given for the purpose of information.

12-05-2010

| Patent document cited in search report | | Publication date | Patent family member(s) | | Publication date |
|---|---|---|---|---|---|
| EP 2007184 | A2 | 24-12-2008 | CN 101330819 A<br>US 2008307817 A1 | | 24-12-2008<br>18-12-2008 |
| US 2009167503 | A1 | 02-07-2009 | WO 2010036561 A2 | | 01-04-2010 |